(19) Europäisches Patentamt
European Patent Office
Office européen des brevets

(11) **EP 3 992 654 A1**

(12) **EUROPEAN PATENT APPLICATION**

(43) Date of publication:
**04.05.2022 Bulletin 2022/18**

(21) Application number: **20204609.0**

(22) Date of filing: **29.10.2020**

(51) International Patent Classification (IPC):
*G01R 33/09* (2006.01)      *G01R 33/12* (2006.01)
*H01F 10/32* (2006.01)      *H03B 15/00* (2006.01)

(52) Cooperative Patent Classification (CPC):
**G01R 33/1284; G01R 33/098; H01F 10/3286;
H01F 10/329; H03B 15/006;** G11B 5/02

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Hitachi, Ltd.
Tokyo (JP)**

(72) Inventors:
• **Roy, Pierre
Cambridge, Cambridgeshire CB3 0HE (GB)**

• **Wunderlich, Joerg
Cambridge, Cambridgeshire CB3 0HE (GB)**

(74) Representative: **Piotrowicz, Pawel Jan Andrzej et al
Venner Shipley LLP
Byron House
Cambridge Business Park
Cowley Road
Cambridge CB4 0WZ (GB)**

Remarks:
Amended claims in accordance with Rule 137(2) EPC.

(54) **SPIN-TORQUE OSCILLATOR MAGNETIC FIELD SENSOR**

(57)    A spin-torque oscillator STO magnetic field sensor (2) is described. The STO magnetic field sensor comprises a layer stack (11) comprising a first ferromagnetic layer (15) which is arranged to provide a fixed layer having a first, out-of-plane magnetisation (Mi), a first spacer layer (16), a second ferromagnetic layer (17) which is arranged to provide a first free layer having a second, in-plane magnetisation (M2). The first spacer layer is sandwiched between the first and second ferromagnetic layers. The layer stack (11) further comprises a second spacer layer (18) and a third ferromagnetic layer (19) which is arranged to provide a second free layer having a third, in-plane magnetisation (M3). The second spacer layer is sandwiched between the second and third ferromagnetic layers. The layer stack (11) further comprises a third spacer layer (20) and a fourth ferromagnetic layer (21) which is arranged to provide a third free layer having a fourth, in-plane magnetisation (M4). The third spacer layer is sandwiched between the third and fourth ferromagnetic layers.

Fig. 1

EP 3 992 654 A1

**Description**

**Field**

The present invention relates to a spin-torque oscillator magnetic field sensor.

**Background**

Detection of currents and magnetic fields with high spatial resolution is of great interest in industrial applications, such as non-destructive testing, electronics and biosensing. Currents produce magnetic fields and so magnetic field sensors can be used for sensing currents, as well for directly probing magnetic specimens. Examples in which high-spatial resolution sensing is desirable include fault detection in small circuitry, detection of defects in material components (such as cracks) and detection of magnetic labels used to tag biomolecules for biosensing.

A device that can achieve nanometre spatial resolution is the spin-torque oscillator (STO) and an example is described in Tingsu Chen et al., Proceedings of the IEEE vol. 104, no. 10, p. 1919 (2016). Although STOs have traditionally been optimized for use as microwave sources, it has been proposed to use them as nanometre-scale magnetic field sensors, mainly as a read head in ultrahigh-density hard disk drives (HDDs). Reference is made to Braganca et al., 2010 Nanotechnology 21 235202, US 8 259 409 B2, US 8 164 861 B2, and US 8 675 309 B2. Reference is also made to US 8,604,886 B2.

In HDD applications, STOs need to sense magnetic field strengths of the order of tens of milliTesla (hundreds of oersted). This, however, is close to the lower limit of detection of existing STOs.

**Summary**

According to a first aspect of the present invention there is provided a spin-torque oscillator magnetic field sensor comprising a layer stack which includes a fixed layer (which may also be referred to a "pinned layer" or "reference layer") which is magnetized out-of-plane (*e.g.*, perpendicular to the layer), and at least three free layers (for example, three layers). In each free layer, a respective magnetization lies in-plane. The magnetic layers (*i.e.*, the fixed and free layers) are separated by spacer layers and are magnetically coupled. The fixed layer exhibits out-of-plane magnetic anisotropy, which may arise from, for example, magnetocrystalline anisotropy. The out-of-plane magnetic anisotropy is preferably strong, in other words, greater than or equal to 100 kJm$^{-3}$ ($1\times10^5$ Jm$^{-3}$) ($1\times10^6$ ergcm$^{-3}$). Each free layer exhibits in-plane-over-out-of-plane magnetic anisotropy, in other words, the magnetization in a free layer has a tendency (or inclination) to be orientated in plane rather than out of plane. Within the plane, each free layer preferably exhibits negligibly small (more preferably substantially no) magnetic anisotropy. For example, the in-plane magnetocrystalline anisotropy energy in a free layer is preferably less than or equal to $1\times10^3$ Jm$^{-3}$. In other words, there is substantially no in-plane axial anisotropy. The in-plane-over-out-of-plane magnetic anisotropy of the free layers may arise, for example, from shape anisotropy, which is a demagnetizing field-induced anisotropy resulting from the shape of the layer, in particular, the layer being made sufficiently thin.

The sensor can be used to sense magnetic fields at lower field strengths, for example, down to 0.1 mT (1 Oe) or even lower. Furthermore, sensor can be operated at lower driving current densities, for example, less than $1\times10^{12}$ Am$^{-2}$, and so help to decrease power consumption.

There may be between three and ten free layers. In some embodiments, there may be only three free layers.

The saturation magnetization of the third ferromagnetic layer may be arranged to be greater than the saturation magnetization of the second ferromagnetic layer and the saturation magnetization of the fourth ferromagnetic layer. The saturation magnetizations of the second and fourth ferromagnetic layers are equal.

Each of the second, third and fourth ferromagnetic layers exhibits in-plane-over-out-of-plane magnetic anisotropy. Each of the second, third and fourth ferromagnetic layers preferably exhibit, within the plane, magnetic isotropy.

Each free layer may comprise a single layer of a ferromagnetic material, such as an alloy of cobalt, iron and boron (CoFeB) or an alloy of iron and nickel (or "permalloy"). Each free layer may have a respective thickness of between 1 and 5 nm.

The spacer layers may comprise a non-magnetic material, preferably the same non-magnetic material. The non-magnetic material may comprise a metal, such as copper (Cu), a metal alloy, a dielectric, such as magnesium oxide (MgO), or other suitable material. The spacer layers may have respective thicknesses which may be between 0.6 and 4 nm. The spacer layers may have the same thickness.

The magnetisation of the fixed layer may be perpendicular to the plane of the fixed layer. The fixed layer has a magnetocrystalline anisotropy energy is preferably greater than or equal to $1\times10^5$ Jm$^{-3}$.

The fixed layer may comprise ferromagnetic alloy, such as cobalt-chromium-platinum (CoCrPt). The fixed layer may comprise multiple layers which include alternating layers of ferromagnetic and non-ferromagnetic materials, such as cobalt and palladium (Co/Pd) or iron and platinum (Fe/Pt), or two different ferromagnetic materials, such as cobalt and nickel (Co/Ni). The fixed layer may have a (total) thickness between 1 and 10 nm.

The spin-torque oscillator magnetic field sensor may comprise a pillar upstanding from a substrate. The pillar may contain at least part of the layer stack. The pillar may contain all of the layer stack. The pillar is preferably cylindrical (*i.e.*, circular cross section). The pillar has a diameter, d, which maybe between 20 and 200 nm, preferably between 30 and 100 nm.

The spin-torque oscillator magnetic field sensor may further comprise first and second electrodes. The layer stack may be sandwiched between the first and second electrodes and connected to the layer stack such that, in response to a voltage or current applied bias between the first and second electrodes, current passes perpendicularly to the layers in the layer stack.

According to a second aspect of the present invention there is provided a system comprising the spin-torque oscillator magnetic field sensor of the first aspect, a voltage or current source arranged to apply a dc bias through the layer stack of the spin-torque oscillator magnetic field sensor; and a first sensor for measuring magnetoresistance of the layer stack (for example, by measuring an oscillating voltage or resistance due to the magnetoresistance) and/or a second sensor for measuring net magnetisation of the layer stack (for example, by measuring an induced voltage due to an oscillating net magnetisation).

The spin-torque oscillator magnetic field sensor and the voltage or current source may be arranged to drive a dc current through the layer stack having a current density less than or equal to $1 \times 10^{12}$ Am$^{-2}$.

According to a third aspect of the present invention there is provided a method of sensing a magnetic field, the method comprising driving a dc current through the layer stack of the spin-torque oscillator magnetic field sensor of the first aspect, and measuring magnetoresistance of the layer stack (for example, by measuring an oscillating voltage or resistance due to the magnetoresistance) and/or measuring net magnetisation of the layer stack (for example, by measuring an induced voltage due to an oscillating net magnetisation).

The dc current may have a current density less than or equal to $1 \times 10^{12}$ Am$^{-2}$.

The method may comprise orientating the spin-torque oscillator magnetic field sensor such that the magnetic field orientation lies parallel to the plane of the free layers.

**Brief Description of the Drawings**

Certain embodiments of the present invention will now be described, by way of example, with reference to the accompanying drawings, in which:

Figure 1 is a schematic diagram of an STO magnetic field sensor system including a STO magnetic field sensor comprising a layer stack which comprises a fixed layer and three free layers;

Figure 2 is a perspective view of a pillar which may contain the layer stack;

Figure 3 is a graph showing magnetization reversal of each free layer in the STO magnetic field sensor shown in Figure 1 over time;

Figure 4A is a plot of magnetoresistance against time for the STO magnetic field sensor shown in Figure 1 at zero applied magnetic field (H=o);

Figure 4B is a steady-state power spectrum plot of magnetoresistance as a function of frequency for the STO magnetic field sensor shown in Figure 1 at zero applied magnetic field (H=o) with a DC current excitation and which is obtained by taking the Fourier transform of the magnetoresistance shown in Figure 4A;

Figure 4C is a plot of the x-component of a volume-averaged net magnetization of the layer stack against time for the STO magnetic field sensor shown in Figure 1 at zero applied magnetic field (H=o);

Figure 4D is a power spectrum plot of a volume-averaged value of the x-component of net magnetization as a function of frequency for the STO magnetic field sensor shown in Figure 1 at zero applied magnetic field (H=o) with a DC current excitation which is obtained by taking the Fourier transform of the magnetoresistance shown in Figure 4C;

Figure 5A is a schematic diagram of an STO magnetic field sensor system including a first comparative example in the form of a STO magnetic field sensor which comprises a fixed layer and one free layer;

Figure 5B is a schematic diagram of an STO magnetic field sensor system including a second comparative example in the form of a STO magnetic field sensor which comprises a fixed layer and two free layers;

Figure 6A is a power spectrum plot of a volume-averaged value of the x-component of the net magnetization of the layer stack as a function of frequency for the first comparative example shown in Figure 5A;

Figure 6B is a power spectrum plot of a volume averaged value of the x-component of the net magnetization of the layer stack as a function of frequency for the second comparative example shown in Figure 5B;

Figure 7A is a power spectrum plot of magnetoresistance against frequency for the STO magnetic field sensor shown in Figure 1 at zero and 0.5 mT applied field;

Figure 7B is a power spectrum plot of a volume-averaged value of the x-component of the net magnetization as a function of frequency for the STO magnetic field sensor shown in Figure 1 at zero and 0.5 mT applied field;
Figure 7C is a power spectrum plot of a volume-averaged value of the x-component of the net magnetization as a function of frequency for the first comparative example shown in Figure 5A at zero and 0.5 mT applied field;
Figure 7D is a power spectrum plot of a volume-averaged value of the x-component of the net magnetization as a function of frequency for the second comparative example shown in Figure 5B at zero and 0.5 mT applied field; and
Figure 8 is a plot of magnetoresistance oscillation and volume-averaged net magnetization oscillation frequency shifts of a fundamental mode against applied magnetic field for the STO magnetic field sensor shown in Figure 1, and frequency-shifts of a volume-averaged net magnetization of a fundamental mode against applied magnetic field for the first comparative example shown in Figure 5A and the second comparative example shown in Figure 5B.

## Detailed Description of Certain Embodiments

STO magnetic field sensor system 1

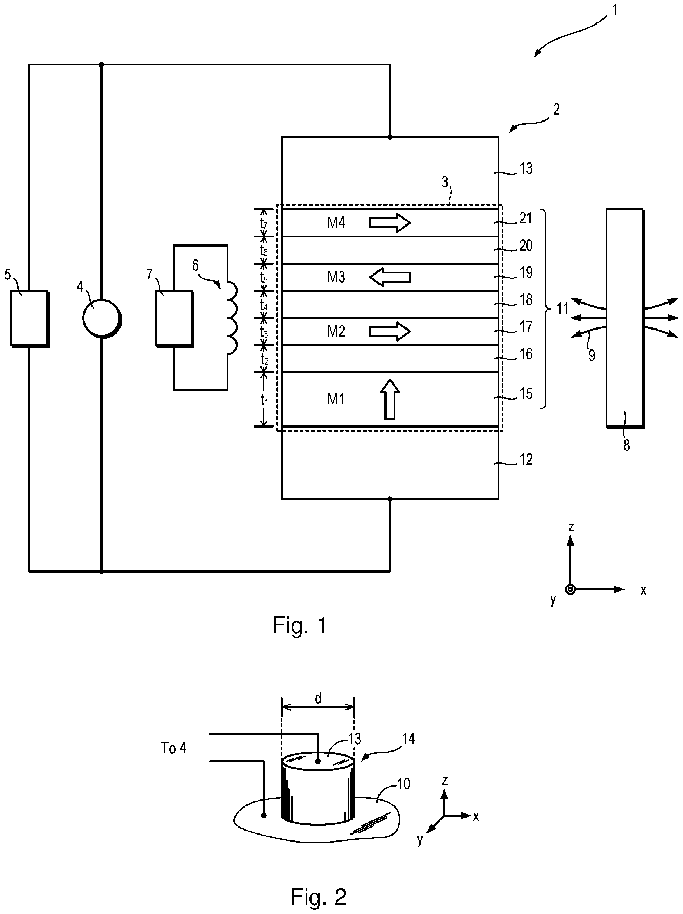

Referring to Figure 1, a spin-torque oscillator (STO) magnetic field sensor system 1 is shown. The system includes an STO magnetic field sensor 2 having a sensing region 3, a bias source 4, which may be a current source or a voltage source, and a first sensor 5 (or "first detector") in the form of a voltage meter, current meter, spectrum analyser, or sampling oscilloscope connected in parallel across the STO magnetic field sensor 2, a coil 6 and a second sensor 7 in the form of a voltage meter, current meter, spectrum analyser, or sampling oscilloscope coupled across the coil 6 and a magnetic field source 8 for applying an external magnetic field 9 to the sensor 2.

The bias source 4 is able to drive a dc current through the STO magnetic field sensor 2. Additionally or alternatively, the bias source 4 may be able to drive an ac current or an ac current with a dc bias through the sensor 2, and so allow phase-sensitive detection, for example, as described in B. Razavi, IEEE J. Solid State Circuits vol. 39, p. 1415 (2004).

Referring also to Figure 2, the STO magnetic field sensor 2 is disposed on a substrate 10 and comprises a layer stack 11 interposed between first and second electrodes 12, 13.

The STO magnetic field sensor 2 may take the form of a pillar 14 upstanding from the substrate 10 and containing the layer stack 11. The pillar 14 may have a diameter, d, between 20 and 200 nm, preferably between 30 and 100 nm. The pilar 14 may be circular in plan view.

The layer stack 11 includes a first ferromagnetic layer 15 having a first magnetisation M1, a first spacer layer 16, a second ferromagnetic layer 17 having a second magnetisation M2, a second spacer layer 18, a third ferromagnetic layer 19 having a third magnetisation M3, a third spacer layer 20, a fourth ferromagnetic layer 21 having a fourth magnetisation M4. The first spacer layer 16 is sandwiched between the first and second ferromagnetic layers 15, 17, the second spacer layer 18 is sandwiched between the second and third ferromagnetic layers 17, 19 and the third spacer layer 20 is sandwiched between the third and fourth ferromagnetic layers 19, 21.

The first ferromagnetic layer 15 is formed of a suitable material having a sufficiently high coercivity to provide a fixed layer (or "pinned layer" or "reference layer"). The fixed layer 15 is arranged to exhibit perpendicular (*i.e.*, perpendicular to the plane of the layer) magnetic anisotropy (*e.g.*, via magnetocrystalline anisotropy) such that its magnetization M1 is orientated perpendicular to the plane. The fixed layer 15 preferably exhibits strong magnetic anisotropy, in other words, a magnetic anisotropy energy (or "constant") which is greater than or equal to $1 \times 10^5$ Jm$^{-3}$ ($1 \times 10^6$ ergcm$^{-3}$) and preferably greater than or equal to $5 \times 10^5$ Jm$^{-3}$ ($5 \times 10^6$ ergcm$^{-3}$).

The fixed layer 15 may comprise a single layer of suitable ferromagnetic material, such as cobalt-chromium-platinum (CoCrPt) alloy or other suitable material, or multiple layers (or "multilayers") which generally include alternating layers of ferromagnetic and non-ferromagnetic materials, such as cobalt and palladium (Co/Pd) or iron and platinum (Fe/Pt), or two different ferromagnetic materials, such as cobalt and nickel (Co/Ni). The first ferromagnetic layer 15 (which may consist of multiple layers) has a thickness $t_1$ which may be between 1 and 10 nm.

The second, third and fourth ferromagnetic layer 17, 19, 21 are formed of a suitable material having a sufficiently low coercivity to provide respective free layers. The free layers 17, 19, 21 are such that their respective magnetizations M2, M3, M4 are orientated in plane, *i.e.*, in the respective plane of the respective free layer, and are free to rotate in plane. This may be achieved, for example, by adapting the thickness of the layer 17, 19, 21 to introduce shape anisotropy. Preferably the free layers 17, 19, 21 exhibit negligible in-plane magnetic anisotropy (even substantially no -plane magnetic anisotropy). In other words, the free layers 17, 19, 21 effectively do not have a preferred in-plane orientation and, thus, are as free as possible to rotate in plane. Each free layer 17, 18, 21 is arranged such that its respective magnetization M2, M3, M4 oscillates in the presence of an excitation current perpendicularly through the plane of the free layer due to spin-transfer torque. For example, the magnetocrystalline anisotropy energy in a free layer may be less than or equal to $1 \times 10^3$ Jm$^{-3}$

The free layers 17, 19, 21 may comprise a single layer of a ferromagnetic material, such as an alloy of cobalt and iron (CoFe), an alloy of cobalt, iron and boron (CoFeB), an alloy of iron and nickel (NiFe) (or "permalloy") or other suitable alloys.

The free layers 17, 19, 21 have an appropriate thickness for the material used to encourage or ensure that their magnetizations are orientated in-plane (as opposed to out-of-plane). The free layers 17, 19, 21 are also sufficiently thin that a spin torque acting on them is strong enough to cause rotor precession for an injected current whose magnitude does not exceed a critical value (that critical value being one which causes tunnelling barrier breakdown or damage to the layer or other layers in the stack).

The second, third and fourth ferromagnetic layers 17, 19, 21 have respective thicknesses $t_3$, $t_5$, $t_7$ which may be between 2 and 5 nm. The second, third and fourth ferromagnetic layers 17, 19, 21 may have the same thickness, i.e., $t_3 = t_5 = t_7$. The second, third and fourth ferromagnetic layers 17, 19, 21 may, however, have different thicknesses.

The saturation magnetization |M3| of the third ferromagnetic layer 19 (*i.e.*, the second, middle free layer) is arranged to be greater than the saturation magnetization |M2| of the second ferromagnetic layer 17 (*i.e.*, the first layer) and the saturation magnetization |M4| of the fourth ferromagnetic layer 21 (*i.e.*, the third free layer) (*i.e.*, |M3| > (|M2|, |M4|). The saturation magnetizations |M2|, |M4| of the second and fourth ferromagnetic layers 17, 21 are equal, i.e., (|M2|= |M4|). The saturation magnetizations |M2|, |M4| of the second and fourth ferromagnetic layers 17, 21 may, however, be unequal.

The spacer layers 16, 18, 20 each comprise a non-magnetic material, preferably the same non-magnetic material. The non-magnetic material may comprise a metal, such as copper (Cu), a metal alloy, a dielectric, such as magnesium oxide (MgO) or aluminium oxide ($Al_2O_3$), or other suitable material. Each spacer layer 16, 18, 20 is sufficiently thin to preserve strong dipolar coupling between the free layers 17, 19, 21. In the case of a metal spacer layer, the thickness of the spacer layer is smaller than the spin diffusion length of the metal (so charge carriers preserve sufficient spin polarization passing through the layer). In the case of a dielectric spacer layer, the spacer layer is sufficiently thin to allow charge carriers to tunnel through the layer and preserve tunnelling magnetoresistance. The spacer layers 16, 18, 20 have respective thicknesses $t_2$, $t_4$, $t_6$ which may be between 0.6 and 4 nm. The spacer layers 16, 18, 20 may have the same thickness, *i.e.*, $t_2 = t_4 = t_6$.

There may be exchange coupling between two magnetic layers 15, 17, 19, 21 across an intermediate spacer layer 16, 18, 20, for example, between the first and second ferromagnetic layers 15, 17 across the first spacer layer 16. There need not be, however, exchange coupling.

The bias source 4 is arranged to drive a current I between the first and second electrodes 12, 13, through the layer stack 11, perpendicular to the layers 15, 16, 17, 18, 19, 20, 21 (i.e., in the direction of stacking) which in this case is along the z-axis. The direction of conventional current is a flow from the first electrode 12 to the second electrode 13.

The first and second electrodes 12, 13 may comprise a non-magnetic electrically-conductive material, such a metal, for example, aluminium (Al) or gold (Au). The electrodes 12, 13 may comprise a layer or multiple layers of materials. The electrodes may comprise an alloy, such as copper/tantalum (Cu/Ta). The electrodes 12, 13 preferably have a sufficiently low surface resistance.

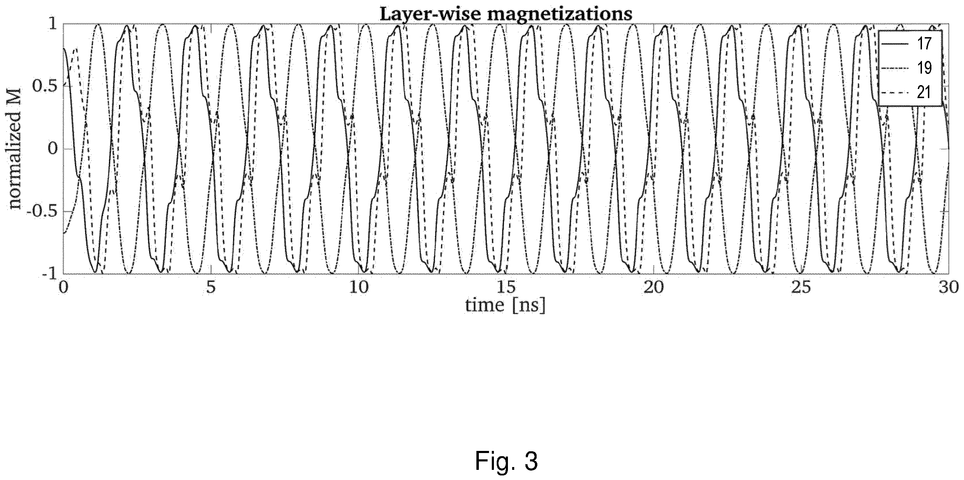

Referring also to Figure 3, as a result of spin transfer torque, the second, third and fourth magnetizations M2, M3, M4 oscillate in an in-plane, rotor-like fashion in response to an excitation current passing perpendicularly through the free layers 17, 19, 21. Through the magnetoresistance effect, the frequency of the variation of resistance may be sensed by the first sensor 5.

Additionally or alternatively, through inductive sensing, the frequency of the variation of resistance may be sensed by the second sensor 7 using the sensing coil 6. This is made possible by the fact the STO magnetic field sensor 2 has a net magnetization due to the third ferromagnetic layer 19 having a different saturation magnetization to the second and fourth ferromagnetic layers 17, 21 (*i.e.*, |M3| ≠ |M2| = |M4|).

The STO stack 11 can be subjected to a magnetic field 9 generated by a magnetic field source 8. The magnetic field 9 may stem from a piece of magnetic material or be a current-generated magnetic field.

Using three (or more) free layers 17, 19, 21, together with a perpendicular fixed layer 15, can help to enhance sensitivity of the STO magnetic field sensor 2 at small magnetic field strengths, for example, below 10 mT (100 Oe), compared to STO magnetic field sensors having only one or two free layers. Furthermore, the sensing region 3 can be nanoscale, for instance, having a volume of between 100 to 1,000 $nm^3$.

Without wishing to be bound by theory, using three (or more) free layers 17, 19, 21 is thought to promote hybridization of acoustic modes in which magnetizations M2, M3, M4 of free layers 17, 19, 21 are driven nearly out-of-phase, in a rotor-like motion. Furthermore, coupling of the free layer stack 17, 19, 21, to a perpendicularly-magnetized fixed layer 15 is thought to facilitate the rotor-like mode from a magnetic stray field point of view (torqueing in particular the first free layer 17) as well as causing perpendicular spin polarisation of electrons interacting with the fixed layer 15 via, for example, reflection. This yields high spin transfer torque efficiency upon the first free layer 17 as the highest spin-torque is realized when the spin-polarisation of the charge carriers (in this case, electrons) are perpendicular to the magnetization of the layer upon which the spin-polarised electrons are acting. High sensitivity at low magnetic field strengths can be achieved using low driving current densities (*e.g.*, less than $1 \times 10^{12}$ $Am^{-2}$ or even less than $1 \times 10^{11}$ $Am^{-2}$).

The sensor 2 is generally configured to detect magnetic fields having a component in a plane which is parallel to the planes of the free layers 17, 19, 21, i.e., in a direction lying parallel to the x-y plane.

Simulation

To characterize the performance of the sensor 2, the Landau-Lifshitz-Gilbert-Slonczewski equation is solved within a full micromagnetic formalism using LLG Micromagnetics Simulator™ (version 4.01) developed by M. Scheinfein.
In the simulations, the following field terms are taken into account, namely intra-layer exchange fields (*i.e.*, within each magnetic layer), inter- and intra-magnetic dipole fields, magnetocrystalline anisotropy and externally-applied field (stemming from source 6). In the simulated data, there is no exchange interaction present between magnetic layers across a spacer layer; in other words, RKKY interaction is set to zero.
Material parameters used for the magnetic layers 15, 17, 19, 21 are as follows:

*First ferromagnetic layer 15*
Saturation magnetization = 600 $kAm^{-1}$,
Exchange stiffness = 15 $pJm^{-1}$,
Perpendicular magnetocrystalline anisotropy constant = $600kJm^{-3}$,
In-plane magnetocrystalline anisotropy constant = 0, and
Layer thickness = 6 nm.

*Second and fourth ferromagnetic layers 17, 21*
Saturation magnetization = 800 $kAm^{-1}$,
Exchange stiffness = 15 $pJ\ m^{-1}$,
Perpendicular Magnetocrystalline anisotropy constant = 0,
In-plane magnetocrystalline anisotropy constant = 0, and
Layer thickness = 3 nm.

*Third ferromagnetic layer 19*
Saturation magnetization = 1000 $kA\ m^{-1}$,
Exchange stiffness = 10.5 $pJm^{-1}$,
Perpendicular magnetocrystalline anisotropy = 0,
In-plane magnetocrystalline anisotropy constant = 0, and
Layer thickness = 3 nm.

The spacer layers 16, 18, 20 each has a thickness of 3 nm.
The Gilbert damping is set to 0.02 for all magnetic layers 15, 17, 19, 21. Spin polarization is set to 0.38.
The diameter of the stack of circular cross-section is set to d = 50 nm.
The discretization cell size is set to 1 nm along the x and y-directions for all layers. The discretization cell thickness (along z) for a layer is set to the thickness of that layer.
A low current of 75 µA (corresponding to a current density of only $3.8 \times 10^{10}$ $Am^{-2}$) is injected into the layer stack 11 and the second, third and fourth magnetizations M2, M3, M4 start oscillating.
Referring again to Figure 3, the behaviours of the second, third and fourth magnetizations M2, M3, M4 corresponding to layers second, third and fourth ferromagnetic layers 17, 19, 21 under zero external magnetic field H = 0 (*i.e.*, when the source 8 does not generate any field) are shown. Figure 3 shows x-projected components of the average magnetizations M2, M3, M4. The y-component of the magnetizations M2, M3, M4 are not shown, but behave in the same way spanning normalized values in the range -1 to 1.
The magnetizations M2, M3, M4 rotate like a rotor in-plane with some distortions, in other words, they are not pure single sine-signals. The magnetizations M2, M3, M4 are mostly - but not quite - out of phase with each other, which leads to a magnetoresistance signal.
As explained hereinbefore, it is possible to detect magnetoresistance (using the first sensor 5) or induced current (using sensor 7).
The magnetoresistance response $R_{ij}$ can be calculated using:

$$R_{ij} = (R_{AP}{}^{ij} + R_P{}^{ij})/2 - [(R_{AP}{}^{ij} - R_P{}^{ij})/2]\ \mathbf{m_i}.\mathbf{m_j} \tag{1}$$

where:

$R_{ij}$ is the resistance between ith and jth magnetic layers 15, 17, 19, 21 (i.e., i = 1 or j = 1 for the first magnetic layer 15, i = 2 or j = 2 for the second magnetic layer 17 and so on)

$R_{Ap}{}^{ij}$ is the resistance between ith and jth magnetic layers 15, 17, 19, 21 when their magnetizations are antiparallel,

$R_{P}{}^{ij}$ is the resistance between ith and jth magnetic layers 15, 17, 19, 21 when their magnetizations are aligned in parallel, and

$\mathbf{m_i.m_j}$ is the dot product of the magnetization vectors in ith and jth magnetic layers 15, 17, 19, 21 (since they are rotating in-plane, this dot product can be seen as their relative angle)

The volume-averaged magnetization that would be sensed by the sensing coil 6 can also be calculated.

The total resistance R is evaluated at a point in time by:

$$R(t) = R_{23}(t) + R_{34}(t) \qquad (2)$$

where

$R_{23}(t)$ is the resistance between second and third magnetic layers 17, 19 at time t, and

$R_{34}(t)$ is the resistance between third and fourth magnetic layers 19, 21 at time t

In the following, two assumptions are made for the sake of simplicity and since only the frequency of R is calculated.

First, it is assumed that the sensor 2 behaves as magnetic tunnel junction with:

$$(R_{AP}{}^{ij} - R_{P}{}^{ij})/ R_{P}{}^{ij} = 100\% \qquad (3)$$

Secondly, it is assumed that $R_P{}^{23} = R_P{}^{34} = R_P$ and, thus:

$$R(t)/ R_P = 3 - [\mathbf{m2.m3 + m3.m4}] \qquad (4)$$

This signal can then be Fast Fourier Transformed (FFT:d) to yield the frequency of the resistance oscillations due to the magnetoresistance effect. This signal based on the magnetoresistance effect may be detected by sensor 5. An oscillatory response of the sensor 2 may also yield a signal based on the volume average of the net magnetization (time dependence of the volume averaged vectorial sum of the constituent ferromagnetic layers' magnetizations). Such a signal is formed taking into account the different saturation magnetizations of the constituent magnetic layers. This signal in the time domain is also Fast Fourier Transformed (FFT:d) to yield the frequency of the oscillation of the volume averaged net magnetization. In the analysis of such a signal herein, the x-component of the volume averaged net magnetization has been utilized.

Detection based on the volume averaged net magnetization may be detected by sensor/detector 7, based on an induced voltage in the coil 6 due to the oscillation of the volume averaged net magnetization.

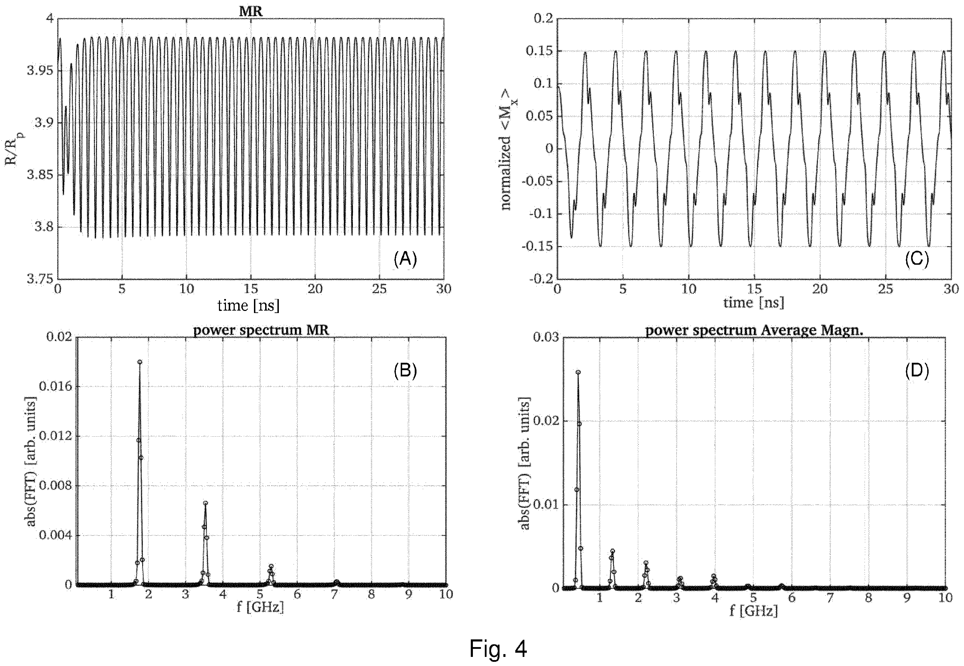

Referring to Figures 4A to 4D, results are shown for the zero external field case.

Referring in particular Figure 4A, a time-dependent magnetoresistance signal is observed.

Referring in particular to Figure 4B, the FFT of the magnetoresistance signal yields a zero external field frequency of the fundamental mode of about 1.77 GHz. Other peaks at higher frequencies away from the highest amplitude peaks are higher harmonics.

Referring in particular to Figures 4C and 4D, the average magnetization signal exhibits a fundamental-mode oscillation frequency of 0.44 GHz. Other peaks at higher frequencies away from the highest amplitude peaks are higher harmonics.

The performance of the sensor 2 can be evaluated as the magnetic field source 8 is turned on to apply a magnetic field 9 along the x-direction. Evaluation involves examining the frequency shift of the highest amplitude modes in the power spectra associated with a given field H. In the following, the evaluation is limited to low-strength magnetic fields, i.e., in the range 0.1 to 0.5 mT (1 to 5 Oe), to evaluate use of the sensor 2 as a nano-scale STO magnetic field sensor for used at low magnetic field used for detecting a low magnetic field.

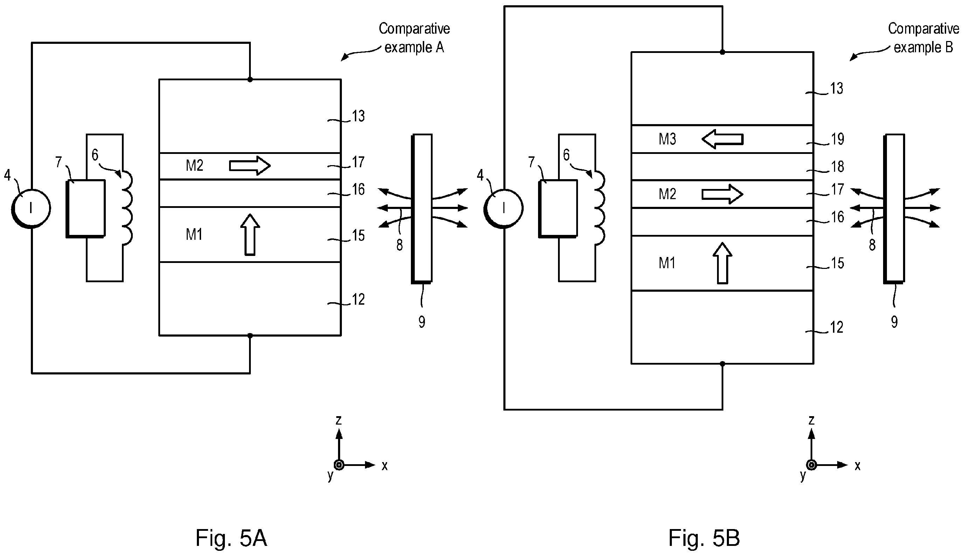

Referring to Figures 5A and 5B, similar calculations are carried out on first and second comparative examples A, B.

The first comparative example A is the same as the sensor 2 (Figure 1) except that it has only one free layer and one spacer layer. The second comparative example B is the same as the sensor 2 (Figure 1) except that it has only two free layers and two spacer layers.

For the first comparative example A, a magnetoresistance response cannot be computed because the only other magnetic layer onto which it is possible to project magnetization is the fixed layer 15, and that projection is zero. Therefore, the first comparative example A can only be sensed using the second sensor 7. The FFT of the average net magnetization's x-component magnetization is taken to extract the zero-field frequency.

For the second comparative example B, the second and third magnetizations M2, M3 are found to be almost exactly out-of-phase. Thus, for the dual free layer STO, the magnetoresistance response is constant and, thus, there is no oscillation of the magnetoresistive signal. Therefore, the second comparative example B is also sensed using the second sensor 7, and the FFT of the average net magnetization is taken to extract the zero-field frequency.

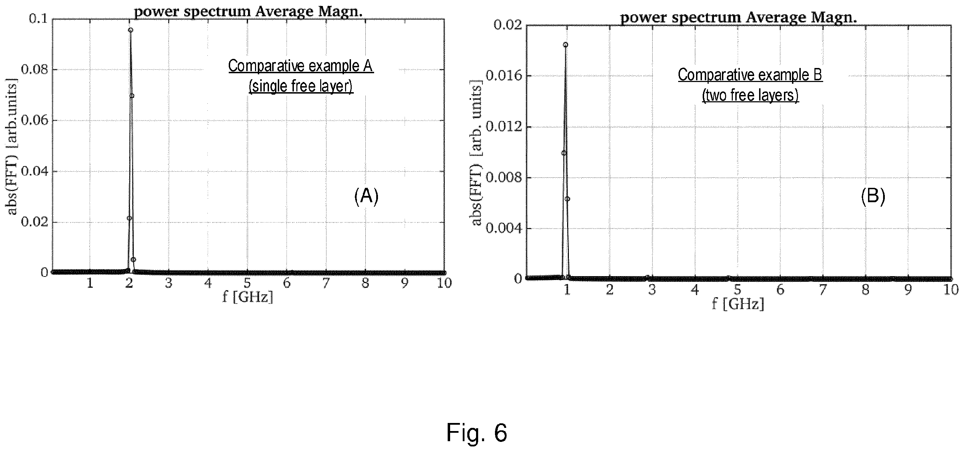

Referring to Figures 6A and 6B, the frequency response in zero field for the first and second comparative examples A, B are shown. The first comparative example A (with a single free layer) exhibits an oscillation frequency of 2.04 GHz. The second comparative example B (with two free layers) oscillates in zero field at 0.96 GHz.

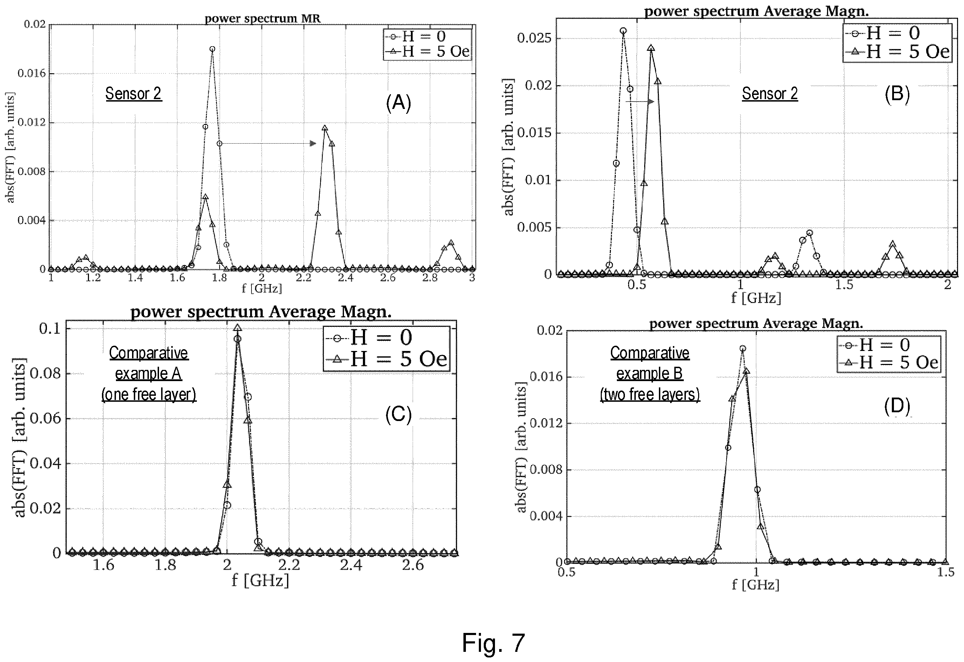

Referring to Figures 7A and 7B, power spectrums of the magnetoresistance response and the average magnetisation for the sensor 2 are shown for zero applied magnetic field and a magnetic field of 0.5 mT (5 Oe) applied along the x axis.

There is noticeable frequency shift of the magnetoresistance response and a smaller but still significant shift in the average magnetization response. Thus, the sensor 2 is able to detect a magnetic field of 0.5 mT (5 Oe).

In Figure 7A, there is a small peak for 0.5 mT (5 Oe) (close to the fundamental mode peak for zero applied magnetic field) at 1.77 GHz. This is not to be interpreted as the fundamental mode when the applied magnetic field is 0.5 mT (5 Oe). The small peak is another field-induced mode which, for smaller applied magnetic fields than 0.5 mT (5 Oe), starts appearing at a much lower frequency and is pushed up towards higher frequencies with increasing applied magnetic field, just happening to coincide with the fundamental mode for zero applied field on the frequency axis at an applied magnetic field value of 0.5 mT (5 Oe).

Referring to Figures 7C and 7D, power spectrums of the average magnetisation for the first and second comparative examples A, B are shown for zero applied magnetic field and a magnetic field of 0.5 mT (5 Oe) applied along the x axis.

For both comparative examples, there is no discernible noticeable shift in frequency, thereby indicating that these devices are less sensitive and less suited to detecting such small magnetic fields.

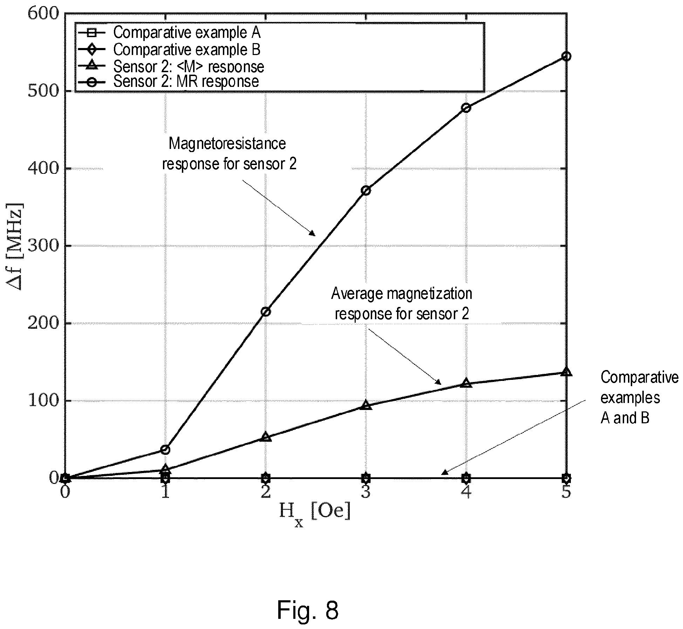

Referring to Figure 8, the responses of the sensor 2 and the first and second comparative examples A, B are shown for even smaller magnetic fields.

The sensor 2 exhibits a shift in response even down to 0.1 mT (1 Oe), whereas the comparative examples A, B exhibit no shift.

Applications

The STO magnetic field sensor 2 herein described can be used in range of different applications.

The sensor 2 can be used to sense currents in nano- or micro-scale circuits. The sensor 2 is positioned close to a current-carrying circuit (not shown) to enable sensing of a current-generated Oersted field having components which are in the plane of the magnetic free layers. The sensor 2 is orientated such that the free layers are parallel to the plane of a current-carrying wire (not shown) and in a relative position such that the sensor 2 is above or below the wire (not shown). For example, the sensor 2 can be mounted on a micron-scale probe arm, such as on a cantilever used in atomic force microscopes. While the sensor 2 is fixed, the circuit under inspection (not shown) can be moved under the sensor 2, for example, using an x-y piezo-stage. Alternatively, the position of the sensor 2 may be fixed on a substrate, while the sensor 2 is fixed, the circuit is passed over the sensor 2.

The sensor 2 can be used for non-destructive testing of materials on a nano- and micro-scale based on magnetic flux leakage. If magnetic flux passes predominately out-of-plane from a surface of a sample under inspection, then the sensor 2 is orientated with the stacking direction of the layer stack is orientated parallel to the surface. The relative orientation of the sensor 2 and sample 8 is shown in Figure 1. If, however, magnetic flux passing from the sample has a predominately in-plane component, then the sensor 2 is oriented with the stacking direction of the layer stack normal to the surface.

The sensor 2 can be used for detecting magnetic nano-particles used in bio-sensing. In such an application, the sensor 2 is positioned upright on a substrate and can be used for either static detection of magnetic nano- or micron-sized particles which are guided to sit on top of the sensor and held in place, for example, by chemical binding to a functionalized surface of the top electrode. The surface can be functionalized in a manner that a magnetic particle will bind to it if the particle has the molecule of interest bound on its surface. Thus, presence of a magnetic nanoparticle on the sensor 2 indicates the presence of the molecule of interest

An advantage of the sensor 2 is that, because it employs the spin torque oscillator, it has a quick response. Thus, the sensor 2 can be used to detect magnetic particles flowing through, for example, a microfluidic channel.

Modifications

It will be appreciated that various modifications may be made to the embodiments hereinbefore described. Such modifications may involve equivalent and other features which are already known in the design, manufacture and use of magnetic field sensors and component parts thereof and which may be used instead of or in addition to features already described herein. Features of one embodiment may be replaced or supplemented by features of another embodiment.

There may be more than three free layers and, accordingly, more than four spacer layers. Preferably, the saturation magnetization(s) of any additional layer(s) is (are) such that it does not create magnetic environments in the layer stack whereby two or more of the free layers have identical magnetic environments. Here "magnetic environment" means the magnetic field(s) felt by (or experienced by) a layer arising from its surroundings due to the presence of other magnetic layers.

The fixed layer may be pinned using an antiferromagnetic layer interposed between the fixed layer and the electrode. Suitable antiferromagnetic layers include alloys of manganese (Mn), such as PtMn, NiMn, FeMn, IrMn and so on. The antiferromagnetic layer may have a thickness between 10 and 25 nm.

The layer stack may be sandwiched between two ferromagnetic electrodes, for example formed of permalloy, to help shield the sensor from magnetic stray fields oriented perpendicular to the planes of the free layers.

Although claims have been formulated in this application to particular combinations of features, it should be understood that the scope of the disclosure of the present invention also includes any novel features or any novel combination of features disclosed herein either explicitly or implicitly or any generalization thereof, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

**Claims**

1. A spin-torque oscillator magnetic field sensor comprising:
   a layer stack comprising:

   a first ferromagnetic layer which is arranged to provide a fixed layer having a first, out-of-plane magnetisation;
   a first spacer layer;
   a second ferromagnetic layer which is arranged to provide a first free layer having a second, in-plane magnetisation, wherein the first spacer layer is sandwiched between the first and second ferromagnetic layers;
   a second spacer layer;
   a third ferromagnetic layer which is arranged to provide a second free layer having a third, in-plane magnetisation, wherein the second spacer layer is sandwiched between the second and third ferromagnetic layers;
   a third spacer layer; and
   a fourth ferromagnetic layer which is arranged to provide a third free layer having a fourth, in-plane magnetisation, wherein the third spacer layer is sandwiched between the third and fourth ferromagnetic layers.

2. The spin-torque oscillator magnetic field sensor of claim 1, wherein the free layers consist of three free layers.

3. The spin-torque oscillator magnetic field sensor of claim 1 or 2, wherein the saturation magnetization of the third ferromagnetic layer is arranged to be greater than the saturation magnetization of the second ferromagnetic layer and the saturation magnetization of the fourth ferromagnetic layer.

4. The spin-torque oscillator magnetic field sensor of any one of claims 1 to 3, wherein the saturation magnetizations of the second and fourth ferromagnetic layers are equal.

5. The spin-torque oscillator magnetic field sensor of any one of claims 1 to 4, wherein each of the second, third and fourth ferromagnetic layers exhibits in-plane-over-out-of-plane magnetic anisotropy.

6. The spin-torque oscillator magnetic field sensor of any one of claims 1 to 5, wherein each of the second, third and fourth ferromagnetic layers exhibits, within the plane, negligible magnetic anisotropy.

7. The spin-torque oscillator magnetic field sensor of any one of claims 1 to 6, wherein each of the second, third and fourth ferromagnetic layers exhibits in-plane magnetocrystalline anisotropy energy less than or equal to $1 \times 10^3$ Jm$^{-3}$.

8. The spin-torque oscillator magnetic field sensor of any one of claims 1 to 7, wherein the first, out-of-plane magnetisation is perpendicular to the plane of the fixed layer.

9. The spin-torque oscillator magnetic field sensor of any one of claims 1 to 8, wherein the fixed layer has a magnetocrystalline anisotropy energy greater than or equal to $1 \times 10^5$ Jm$^{-3}$.

10. The spin-torque oscillator magnetic field sensor of any one of claims 1 to 9, comprising a pillar upstanding from a substrate, wherein the pillar contains at least part of, optionally all of, the layer stack.

11. The spin-torque oscillator magnetic field sensor of any one of claims 1 to 10, further comprising:
first and second electrodes, wherein the layer stack is sandwiched between the first and second electrodes and connected to the layer stack such that, in response to a voltage or current applied bias between the first and second electrodes, current passes perpendicularly to the layers in the layer stack.

12. A system comprising:

the spin-torque oscillator magnetic field sensor of any one of claims 1 to 11;
a voltage or current source arranged to apply a dc bias through the layer stack of the spin-torque oscillator magnetic field sensor; and
a first sensor for measuring magnetoresistance of the layer stack and/or a second sensor for measuring net magnetisation of the layer stack.

13. The system of claim 12, wherein the spin-torque oscillator magnetic field sensor and the voltage or current source are arranged to drive a dc current through the layer stack having a current density less than or equal to $1 \times 10^{12}$ Am$^{-2}$.

14. A method of sensing a magnetic field, the method comprising:

driving a dc current through the layer stack of the spin-torque oscillator magnetic field sensor of any one of claims 1 to 11; and
measuring magnetoresistance of the layer stack and/or measuring net magnetisation of the layer stack.

15. The method of claim 14, wherein the dc current has a current density less than or equal to $1 \times 10^{12}$ Am$^{-2}$.


**Amended claims in accordance with Rule 137(2) EPC.**

1. A spin-torque oscillator magnetic field sensor (2) comprising:
a layer stack (11) comprising:

a first ferromagnetic layer (15) which is arranged to provide a fixed layer having a first, out-of-plane magnetisation (M1);
a first spacer layer (16);
a second ferromagnetic layer (17) which is arranged to provide a first free layer having a second, in-plane magnetisation (M2), wherein the first spacer layer is sandwiched between the first and second ferromagnetic layers;
a second spacer layer (18);
a third ferromagnetic layer (19) which is arranged to provide a second free layer having a third, in-plane magnetisation (M3), wherein the second spacer layer is sandwiched between the second and third ferromagnetic layers;
a third spacer layer (20); and
a fourth ferromagnetic layer (21) which is arranged to provide a third free layer having a fourth, in-plane magnetisation (M4), wherein the third spacer layer is sandwiched between the third and fourth ferromagnetic layers,

wherein each of the second, third and fourth ferromagnetic layers exhibits, within the plane, negligible magnetic anisotropy.

2. The spin-torque oscillator magnetic field sensor (2) of claim 1, wherein the number of free layers is equal to three.

3. The spin-torque oscillator magnetic field sensor (2) of claim 1 or 2, wherein the saturation magnetization ($|M_3|$) of the third ferromagnetic layer (19) is arranged to be greater than the saturation magnetization ($|M_2|$) of the second ferromagnetic layer (17) and the saturation magnetization ($|M_4|$) of the fourth ferromagnetic layer (21).

4. The spin-torque oscillator magnetic field sensor (2) of any one of claims 1 to 3, wherein the saturation magnetizations ($|M_2|$, $|M_4|$) of the second and fourth ferromagnetic layers (17, 21) are equal.

5. The spin-torque oscillator magnetic field sensor of any one of claims 1 to 4, wherein each of the second, third and fourth ferromagnetic layers (17, 19, 21) exhibits in-plane-over-out-of-plane magnetic anisotropy.

6. The spin-torque oscillator magnetic field sensor (2) of any one of claims 1 to 5, wherein each of the second, third and fourth ferromagnetic layers (17, 19, 21) exhibits in-plane magnetocrystalline anisotropy energy less than or equal to $1 \times 10^3 Jm^{-3}$.

7. The spin-torque oscillator magnetic field sensor (2) of any one of claims 1 to 6, wherein the first, out-of-plane magnetisation (M1) is perpendicular to the plane of the fixed layer.

8. The spin-torque oscillator magnetic field sensor (2) of any one of claims 1 to 7, wherein the fixed layer has a magnetocrystalline anisotropy energy greater than or equal to $1 \times 10^5 Jm^{-3}$.

9. The spin-torque oscillator magnetic field sensor (2) of any one of claims 1 to 8, comprising a pillar (14) upstanding from a substrate (10), wherein the pillar contains at least part of, optionally all of, the layer stack (11).

10. The spin-torque oscillator magnetic field sensor (2) of any one of claims 1 to 9, further comprising:
    first and second electrodes (12, 13), wherein the layer stack (11) is sandwiched between the first and second electrodes and connected to the layer stack such that, in response to a voltage or current applied bias between the first and second electrodes, current passes perpendicularly to the layers in the layer stack.

11. A system comprising:

    the spin-torque oscillator magnetic field sensor (2) of any one of claims 1 to 10;
    a voltage or current source (4) arranged to apply a dc bias through the layer stack (11) of the spin-torque oscillator magnetic field sensor; and
    a first sensor (5) for measuring magnetoresistance of the layer stack and/or a second sensor (7) for measuring net magnetisation of the layer stack.

12. The system of claim 11, wherein the spin-torque oscillator magnetic field sensor (2) and the voltage or current source (4) are arranged to drive a dc current through the layer stack (11) having a current density less than or equal to $1 \times 10^{12} Am^{-2}$.

13. A method of sensing a magnetic field, the method comprising:

    driving a dc current through the layer stack (11) of the spin-torque oscillator magnetic field sensor (2) of any one of claims 1 to 10; and
    measuring magnetoresistance of the layer stack and/or measuring net magnetisation of the layer stack.

14. The method of claim 13, wherein the dc current has a current density less than or equal to $1 \times 10^{12} Am^{-2}$.

1

2

13

3

| | | | 21 |
| $t_7$ | M4 → | | 20 |
| $t_6$ | | | 19 |
| $t_5$ | M3 ← | | 18 |
| $t_4$ | | | 17 |
| $t_3$ | M2 → | | 16 |
| $t_2$ | | | 15 |
| $t_1$ | M1 ↑ | | |

11

9

8

5

4

7

6

12

z

y

x

**Fig. 1**

d

To 4

13

14

10

z

x

y

**Fig. 2**

Layer-wise magnetizations

Fig. 3

EP 3 992 654 A1

Fig. 4

Fig. 5A

Fig. 5B

EP 3 992 654 A1

Fig. 6

Fig. 7

Fig. 8

Europäisches
Patentamt

European
Patent Office

Office européen
des brevets

# EUROPEAN SEARCH REPORT

**Application Number**

EP 20 20 4609

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/303997 A1 (WANG JIAN-PING [US] ET AL) 15 December 2011 (2011-12-15) | 1,2,8-15 | INV.<br>G01R33/09 |
| Y | * paragraphs [0040] - [0042], [0050] - [0061]; figures 1, 5 * | 3,5 | G01R33/12<br>H01F10/32<br>H03B15/00 |
| X | US 2008/268291 A1 (AKIYAMA JUNICHI [JP] ET AL) 30 October 2008 (2008-10-30) | 1,2,5-15 | |
| Y | * paragraphs [0045] - [0053], [0089] - [0094]; figures 1B, 2, 11A, 18 * | 1-15 | |
| Y | US 2012/170357 A1 (APALKOV DMYTRO [US] ET AL) 5 July 2012 (2012-07-05)<br>* paragraphs [0025] - [0030]; figures 3-7 * | 1,2,5-15 | |
| Y | US 2014/151831 A1 (CHEN EUGENE [US] ET AL) 5 June 2014 (2014-06-05)<br>* paragraphs [0085] - [0088]; figure 11 * | 1,2,5-15 | |
| Y | US 2011/109397 A1 (DELAET BERTRAND [FR] ET AL) 12 May 2011 (2011-05-12)<br>* paragraphs [0035], [0061] - [0084]; figure 1 * | 1-15 | TECHNICAL FIELDS SEARCHED (IPC)<br><br>G01R<br>H03D<br>H01F<br>H03B<br>G11B |

The present search report has been drawn up for all claims

| Place of search | Date of completion of the search | Examiner |
|---|---|---|
| Munich | 12 April 2021 | Philipp, Peter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 20 20 4609

This annex lists the patent family members relating to the patent documents cited in the above-mentioned European search report.
The members are as contained in the European Patent Office EDP file on
The European Patent Office is in no way liable for these particulars which are merely given for the purpose of information.

12-04-2021

| Patent document cited in search report | | | Publication date | Patent family member(s) | | | Publication date |
|---|---|---|---|---|---|---|---|
| US 2011303997 | A1 | | 15-12-2011 | NONE | | | |
| US 2008268291 | A1 | | 30-10-2008 | CN | 101295508 | A | 29-10-2008 |
| | | | | JP | 2008277586 | A | 13-11-2008 |
| | | | | KR | 20080096463 | A | 30-10-2008 |
| | | | | US | 2008268291 | A1 | 30-10-2008 |
| US 2012170357 | A1 | | 05-07-2012 | NONE | | | |
| US 2014151831 | A1 | | 05-06-2014 | CN | 103855299 | A | 11-06-2014 |
| | | | | KR | 20140071260 | A | 11-06-2014 |
| | | | | TW | 201428951 | A | 16-07-2014 |
| | | | | US | 2014151831 | A1 | 05-06-2014 |
| US 2011109397 | A1 | | 12-05-2011 | EP | 2323252 | A1 | 18-05-2011 |
| | | | | FR | 2952486 | A1 | 13-05-2011 |
| | | | | JP | 2011101015 | A | 19-05-2011 |
| | | | | US | 2011109397 | A1 | 12-05-2011 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8259409 B2
- US 8164861 B2
- US 8675309 B2
- US 8604886 B2

**Non-patent literature cited in the description**

- **TINGSU CHEN et al.** *Proceedings of the IEEE,* 2016, vol. 104 (10), 1919
- **BRAGANCA et al.** *Nanotechnology,* 2010, vol. 21, 235202
- **B. RAZAVI.** *IEEE J. Solid State Circuits,* 2004, vol. 39, 1415